# EUROPÄISCHE PATENTSCHRIFT

(11) **EP 2 949 500 B1**
(45) Veröffentlichungstag und Bekanntmachung des Hinweises auf die Patenterteilung: **17.05.2017**
(21) Anmeldenummer: 14169996.7
(22) Anmeldetag: 27.05.2014
(51) Int. Cl.: B60L 1/00, B60L 11/18, H01M 8/00, H05K 5/00

(54) **Antriebskreis- und Brennstoffzellenkompressor-Energieversorgungs- und Regelungseinheit**
Drive circuit and fuel cell compressor energy supply and regulation unit
Unité d'alimentation en énergie et de régulation d'un compresseur à circuit d'entraînement et à cellules de combustion

(43) Veröffentlichungstag der Anmeldung: 02.12.2015
(73) Patentinhaber: Brusa Elektronik AG, 9466 Sennwald (CH)
(72) Erfinder: Matt, Philipp, 6820 Frastanz (AT); Friewald, Kai, 6800 Feldkirch (AT); Schiedermeier, Max, 9466 Sennwald (CH)
(74) Vertreter: Patentbüro Paul Rosenich AG

(56) Entgegenhaltungen:
- WO-A1-2014/013606
- DE-A1- 10 332 129
- DE-A1-102008 047 387
- DE-A1-102012 208 197
- DE-A1-102012 220 795
- DE-T5-112009 004 862
- JP-B2- 5 435 028
- US-A1- 2014 132 193
- Monzer Al Sakka ET AL: "3 DC/DC Converters for Electric Vehicles", , 2011, Seiten 1-25, XP055160688, ISBN: 978-9-53-307477-1 Gefunden im Internet: URL:http://cdn.intechopen.com/pdfs-wm/1958 3.pdf [gefunden am 2015-01-08]

## Beschreibung

Die Erfindung betrifft eine Energieversorgungs- und Regelungseinheit zur Versorgung eines Antriebskreises, insbesondere eines Traktionsantriebskreises, und eines Brennstoffzellenkompressors sowie einen Brennstoffzellenantrieb.

Bei der Herstellung von Brennstoffzellenfahrzeugen stellen geringer Bauraum und hohe Kompaktheit von Komponenten wichtige Anforderungen dar. Einen wesentlichen Punkt stellt auch die Energieversorgung und Regelung des Brennstoffzellenkompressors dar. Dieser, üblicherweise als Turbokompressor ausgebildete Kompressor dient zur dynamischen Bewirtschaftung der Brennstoffzellen mit dem Gas der Kathode (i.d.R. mit Luft). Dabei entstehen bei der erforderlichen Spannungswandlung hohe Wärmemengen, deren Abführung auf engstem Raum eine große Herausforderung darstellt. Zudem soll der Einbau, Austausch und Wartung von Komponenten, die die Energieversorgung des Brennstoffzellenkompressors sicherstellen, möglichst einfach und kostengünstig erfolgen können. Eine Lösung nach dem Stand der Technik ist in der Patentanmeldung DE11 2009 004 862 T5 (Toyota) beschrieben. Die im Stand der Technik bekannten Lösungen stellen in Bezug auf diese Gesichtspunkte nur unbefriedigende Lösungen bereit. Der erforderliche Bauraum für die elektrischen Versorgungskomponenten ist aufgrund der vielen funktionalen Untereinheiten verhältnismäßig groß. Auch das damit einhergehende Gewicht schlägt sich negativ auf die Leistungsfähigkeit solcher Fahrzeuge nieder. Um zu herkömmlichen Antriebssystemen dauerhaft konkurrenzfähig zu werden, müssen neue Ansätze auch kostengünstigere Lösungen bereitstellen.

Diese Anforderungen verschärfen sich insbesondere im Zusammenhang mit Brennstoffzellenantrieben, die z.B. in Bussen oder anderen Nutzfahrzeugen, PKWs, Jachten, Bau- und Werkzeugmaschinen zur Anwendung kommen können. Neben der ohnedies erforderlichen Batterie ist hier zusätzlicher Raum für eine Brennstoffzelleneinheit, auch Brennstoffzellen-Stack genannt, bereitzustellen. Ein ebenso leistungsfähiger DC/DC-Wandler (Hochsetzsteller) ist für die Umwandlung der Ausgangsspannung der Brennstoffzelleneinheit vorzusehen. Eine entsprechende Kühlung sowohl der Brennstoffzelleneinheit als auch des DC/DC-Wandlers ist bei der Dimensionierung solcher Systeme zu berücksichtigen.

Aufgabe der vorliegenden Erfindung ist es somit, den oben genannten Anforderungen besser gerecht zu werden als bislang bekannte Lösungen. Es soll eine Energieversorgungs- und Regelungseinheit für einen Brennstoffzellenkompressor sowie ein Brennstoffzellenantrieb bzw. -fahrzeug bereitgestellt werden, bei dem der für die elektrischen Komponenten der Energieversorgungs- und Regelungseinheit erforderliche Bauraum minimiert werden kann. Die Lösung soll sich durch geringes Gewicht und Volumen, hohe Kompaktheit und hohe Effizienz auszeichnen und kostengünstig sein. Einbau, Austausch und Wartung soll ebenso einfach wie ohne viel Aufwand bewerkstelligt werden können.

Die Aufgabe wird gelöst mit einer Energieversorgungs- und Regelungseinheit zur Versorgung eines Antriebskreises, insbesondere eines Traktionsantriebskreises, und eines Brennstoffzellenkompressors über gesonderte Schnittstellen, umfassend
- einen DC/DC-Wandler mit einer Brennstoffzellen-Eingangsschnittstelle,
- einen Wechselrichter,
- eine Antriebskreis-Schnittstelle zum Anschluss an einen Antriebskreis, und
- eine Kompressormotor-Schnittstelle (6) zum Anschluss an einen Kompressormotor (3) eines Brennstoffzellenkompressors,

wobei der Ausgang des DC/DC-Wandlers mit dem Eingang des Wechselrichters und mit der Antriebskreis-Schnittstelle verbunden ist, und wobei der Ausgang des Wechselrichters mit der Kompressormotor-Schnittstelle verbunden ist, und wobei der DC/DC-Wandler und der Wechselrichter in einem gemeinsamen Gehäuse untergebracht sind. Die Verbindung zwischen dem Ausgang des DC/DC-Wandlers und dem Eingang des Wechselrichters verläuft ebenfalls innerhalb des Gehäuses. Bei der Erfindung handelt es sich gleichzeitig um eine Antriebskreisversorgungs- und regelungseinheit für einen Antriebsmotor und eine Kompressorenergieversorgungs- und regelungseinheit für den Kompressormotor eines Brennstoffzellenkompressors. Die erfindungsgemäße Einheit erlaubt die gleichzeitige Stromversorgung des Antriebsmotors und des Kompressormotors. Die erfindungsgemäße Einheit integriert somit zwei verschiedene Funktionen. Die Antriebskreis-Schnittstelle und die Kompressormotor-Schnittstelle sind gesonderte Schnittstellen, wobei an ersterer Gleichstrom (bzw. Gleichspannung) und an letzterer Wechselstrom bereitgestellt wird.

Unter Antriebskreis wird der elektrische Kreis bzw. die elektrische Verbindung zum Antriebsmotor hin verstanden. Dieser dient der Versorgung des Antriebsmotors mit elektrischer Leistung bzw. der Leistungsübertragung.

Der Antriebskreis umfasst vorzugsweise einen elektrischen Energiespeicher, wie eine (Fahrzeug)Batterie, und einen Antriebsumrichter (bzw. Traktionsumrichter). In einem bevorzugten Anwendungsfall ist der elektrische Energiespeicher direkt mit der Antriebskreis-Schnittstelle der Energieversorgungs- und Regelungseinheit verbunden, während der Antriebsumrichter zwischen Energiespeicher und Antriebsmotor geschaltet ist. Der Antriebsumrichter und die Batterie sind vorzugsweise außerhalb des Gehäuses, in dem DC/DC-Wandler und Wechselrichter sitzen, angeordnet.

Die Energieversorgungs- und Regelungseinheit regelt:
- einerseits den Eingangsstrom in den DC/DC-Wandler (d.h. regelt, wie viel Strom aus der Brennstoffzelleneinheit gezogen wird) - dies kann lastabhängig bzw. je nach Leistungsbedarf erfolgen, sodass entsprechender Strom an der Antriebskreis-Schnittstelle bereitgestellt wird;
- andererseits den (Wechsel)Strom am Ausgang des Wechselrichters (d.h. den in den Kompressormotor gehenden Strom) - dadurch kann ebenfalls leistungsabhängig der Kompressormotor und damit die Verbrennungsgaszufuhr geregelt werden.

Üblicherweise weist der Kompressormotor im Vergleich zu einem an den Antriebskreis angebundenen Antriebsmotor (Traktionsmotor) untergeordneten Leistungsbedarf auf. Nur beispielhaft könnte z.B. der DC/DC-Wandler auf eine Leistung von 80kW ausgelegt sein, während der Wechselrichter auf eine Leistung von 15kW ausgelegt sein kann. Der Wechselrichter kann dadurch wesentlich kleiner dimensioniert werden.

Als 'Brennstoffzellen-Eingangsschnittstelle' des DC/DC-Wandlers ist jene Schnittstelle zu verstehen, welche für die Verbindung mit der Brennstoffzelleneinheit dient. Als 'Ausgang' des DC/DC-Wandlers, wird jene leistungsführende Schnittstelle betrachtet, die mit dem leistungsführenden 'Eingang' des Wechselrichters verbunden ist. Der Ausgang des DC/DC-Wandlers und der Eingang des Wechselrichters sind für Spannungen von zumindest 100V, vorzugsweise von zumindest 200V, besonders bevorzugt von zumindest 400V ausgelegt. Sie können demnach auch als HV(high voltage)-Schnittstellen bezeichnet werden.

Die 'Kompressormotor-Schnittstelle' dient zur Verbindung mit dem Kompressormotor eines (Turbo-)kompressors. Der Wechselrichter kann somit auch als Brennstoffzellenkompressor-Wechselrichter bezeichnet werden. Ein Brennstoffzellenkompressor dient zur dynamischen Bewirtschaftung der Brennstoffzellen, d.h. zur dynamischen Bereitstellung von Verbrennungsluft, insbesondere Luft, an der/den Kathode(n) der einzelnen Brennstoffzellen.

Die Energieversorgungs- und Regelungseinheit ist dazu konzipiert, einen Wechselstrom zum Antreiben des Brennstoffzellenkompressors, dessen Motor ein Wechselstrommotor ist, bereitzustellen (Energieversorgung). Gleichzeitig übernimmt die Energieversorgungs- und Regelungseinheit die Aufgabe der Steuerung des Brennstoffzellenkompressors (Regelung). Dies erfolgt dadurch, dass der Ausgangswechselstrom des Wechselrichters entsprechend der aktuellen Anforderung (Leistungsbedarf aus der Brennstoffzelle) geregelt wird. Diese Regelungsaufgaben können vom DC/DC-Wandler und/oder vom Wechselrichter übernommen werden.

Der DC/DC-Wandler und der Wechselrichter umfassen dabei einen Steuereingang (der auch als gemeinsamer Steuereingang ausgebildet sein kann). Der DC/DC-Wandler ist vorzugsweise derart ausgebildet, dass das Verhältnis zwischen der DC-Eingangsspannung und der DC-Ausgangsspannung oder dass der Eingangsstrom des DC/DC-Wandlers (entspricht dem Ausgangsstrom der Brennstoffzelleneinheit) über den Steuereingang regelbar ist. Die Regelung des DC-Eingangsstromes wird dabei bevorzugt: Je nach Leistungsbedarf wird mehr oder weniger Strom aus der Brennstoffzelleneinheit gezogen (höherer Strom bedeutet höhere Leistung). Der Wechselrichter ist derart ausgebildet, dass der Ausgangswechselstrom im Hinblick auf die DC-Ausgangsspannung des DC/DC-Wandlers über den Steuereingang regelbar ist. Die Regelung erfolgt über eine entsprechende Ansteuerung der jeweiligen Schaltmodule in den einzelnen Komponenten.

Der wesentliche Vorteil der Erfindung ergibt sich daraus, dass für die genannten Komponenten nur mehr ein gemeinsames Gehäuse und z.T. auch gemeinsame Schnittstellen erforderlich sind, wodurch der Bauraum wesentlich reduziert werden kann. Unter dem Ausdruck 'gemeinsames Gehäuse' wird in dieser Anmeldung auch verstanden, dass das Gehäuse auch aus zwei oder mehreren Gehäuseteilen zusammengesetzt sein kann, die z.B. aneinander geflanscht sind. Die jeweils von den einzelnen Gehäuseteilen umschlossenen Räume sind jedoch miteinander verbunden bzw. bilden einen gemeinsamen Innenraum.

Insbesondere im Hinblick auf die Mechanik ergeben sich wichtige Vorteile: Es ist nur ein Gehäuse, ein Hauptdeckel bzw. Wasserdeckel (d.h. ein Deckel zum Verschluss und Abdichten des gemeinsamen Kühlkanals) und eine Druckausgleichsmembran nötig. Die Druckausgleichsmembran gleicht Druckdifferenzen aus, die z.B. durch Temperaturunterschiede zwischen dem Gehäuseinneren und außen entsteht. Die erfindungsgemäße Energieversorgungseinheit stellt eine in sich geschlossene bauliche Einheit dar.

Die Energieversorgungseinheit weist eine Antriebskreis-Schnittstelle auf, die mit dem Antriebskreis, insbesondere mit einem elektrischen Energiespeicher des Antriebskreises (i.d.R. Fahrzeugbatterie) verbunden wird. Die Antriebskreis-Schnittstelle ist vorzugsweise eine gemeinsame Schnittstelle von DC/DC-Wandler und Wechselrichter. Dies bedeutet, dass sowohl der Ausgang des DC/DC-Wandlers als auch der Eingang des Wechselrichters mit dieser gemeinsamen Schnittstelle verbunden sind bzw. in diese einmünden.

Die Brennstoffzelleneinheit ist mit der Brennstoffzellen-Eingangsschnittstelle des DC/DC-Wandlers verbunden. Die aus den Brennstoffzellen bzw. der Brennstoffzelleneinheit gewonnene und vom DC/DC-Wandler an dessen Ausgang bereitgestellte, hohe Leistung erfordert normalerweise entsprechend dimensionierte, und daher teure Schnittstellen (Stecker) und Filter (EMV-Filter), insbesondere zwischen dem DC/DC-Wandler, der die Ausgangsspannung der Brennstoffzelleneinheit konvertiert (insbesondere hochsetzt), und der Fahrzeugbatterie. Durch die erfindungsgemäße Konzeption können Schnittstellen und Filter in puncto Volumen, Gewicht, Kosten und Effizienz wesentlich vorteilhafter dimensioniert werden.

Durch die gemeinsame (d.h. von DC/DC-Wandler und Wechselrichter gemeinschaftlich genutzte) Antriebskreis-Schnittstelle kann nicht nur der Leitungsaufwand reduziert werden, denn es ist nun nur mehr eine (gemeinsame) Leitung zwischen der Energieversorgungs- und Regelungseinheit und dem Energiespeicher des Antriebskreises erforderlich, sondern kann diese gemeinsame Antriebskreis-Schnittstelle wesentlich kleiner (d.h. für kleinere Leistungen konzeptioniert) ausfallen. Der Grund dafür ist, dass ein nicht unerheblicher Teil der Leistung, welche von den Brennstoffzellen über den DC/DC-Wandler bereitgestellt wird, bereits innerhalb der Energieversorgungs- und Regelungseinheit bzw. innerhalb des gemeinsamen Gehäuses vom Wechselrichter verbraucht wird. Dies bedeutet, dass weniger Strom aus dem gemeinsamen Gehäuse der Energieversorgungs- und Regelungseinheit fließt. Aus dem genannten Grund kann der batterieseitige Stecker kleiner dimensioniert werden. Verglichen mit Konzepten, welche im DC/DC-Wandler einen Nebenaggregatsstecker für die Versorgung des Turbokompressormotor-Wechselrichters vorsehen, kann dieser Nebenaggregatsstecker hier durch die erfindungsgemäße Konzeption entfallen.

Ähnliche Vorteile ergeben sich bei einem von DC/DC-Wandler und Wechselrichter gemeinschaftlich verwendeten Filter, insbesondere EMV-Filter. Wie bereits erwähnt wird ein Teil der Leistung bereits innerhalb des gemeinsamen Gehäuses vom Wechselrichter verbraucht. Dadurch, dass ein Teil des Ausgangsstromes des DC/DC-Wandlers bereits geräteintern in den Wechselrichter fließt, fließt weniger Strom durch den Filter bzw. den Stecker zwischen dem DC/DC-Wandler und dem Antriebskreis, insbesondere dessen Energiespeicher. Effektiv kann deshalb das Filter kleiner ausfallen, wodurch sich Vorteile in puncto Gewicht, Bauraum, Kosten, und Wirkungsgrad ergeben.

Schließlich umfasst die Energieversorgungs- und Regelungseinheit eine Kompressormotor-Schnittstelle, an der der Wechselrichter eine vorzugsweise 3-phasige Wechselspannung bereitstellt, zum Anschluss an einen Brennstoffzellenkompressormotor. Schnittstellen für andere Nebenaggregate können ebenfalls vorgesehen sein.

Eine besonders bevorzugte Ausführungsform zeichnet sich dadurch aus, dass die Energieversorgungs- und Regelungseinheit eine Brennstoffzelleneinheit umfasst, die mit der Brennstoffzellen-Eingangsschnittstelle des DC/DC-Wandlers verbunden ist und in demselben Gehäuse untergebracht ist wie der DC/DC-Wandler und der Wechselrichter. Unter dem Ausdruck ,in demselben Gehäuse' wird u.a. auch verstanden, dass das Gehäuse aus zwei oder mehreren Gehäuseteilen zusammengesetzt ist, die z.B. aneinander geflanscht sein können. Die jeweils von den einzelnen Gehäuseteilen umschlossenen Räume sind jedoch miteinander verbunden bzw. bilden einen gemeinsamen Innenraum. Dies ermöglicht eine direkte mechanische und elektrische Kopplung ohne Einsatz von Kabeln. Die Energieversorgungs- und Regelungseinheit übernimmt hier nicht nur die Funktion der (mehrstufigen) Konvertierung der Leistung und der Abzweigung in Richtung Energiespeicher, sondern enthält auch die Energiequelle selbst. Durch die räumliche Nähe und die Anordnung in einem gemeinsamen Gehäuse werden lange und daher verlustbehaftete Leitungen und Verbindungsstecker vermieden und können gemeinsame Einrichtungen, wie Kühlung, Spannungs- und/oder Temperaturmessung, etc., verwendet werden, was zu einer Reduktion der erforderlichen Komponenten und einer deutlichen Gewichtsminderung führt. Die Energiequelle (eine Brennstoffzelleneinheit umfasst mehrere miteinander verschaltete Brennstoffzellen) und die Einrichtungen zur Energiekonvertierung stellen eine bauliche Einheit dar. Die nunmehr überschaubare Anzahl von Schnittstellen vereinfacht den Zusammenbau und reduziert die Herstellungskosten.

Wenn auch die Brennstoffzelleneinheit im gemeinsamen Gehäuse integriert ist, umfasst das Gehäuse eine Zufuhrschnittstelle für das Verbrennungsgas (Gas für die Kathode) eine Zufuhrschnittstelle für den Brennstoff (Wasserstoff) und eine Abfuhrschnittstelle für das bei der Verbrennung entstehende Wasser. Diese Schnittstellen münden innerhalb des Gehäuses in der Brennstoffzelleneinheit.

Bevorzugt ist das gemeinsame Gehäuse wasserdicht, vorzugsweise auch luftdicht, abgeschlossen. Bei Verwendung einer Druckausgleichsmembran ist das Gehäuse nur wasserdicht, wobei ein Gasaustauch zum Ausgleich von Druckdifferenzen ermöglicht wird. D.h. das Innere des Gehäuses ist nach außen hin abgedichtet, insbesondere vor Feuchtigkeit geschützt. Diese Ausführungsform stellt eine hermetisch abgedichtete bauliche Einheit dar. Nicht zum 'Inneren des Gehäuses' zählen in diesem Zusammenhang das Innere von in der Energieversorgungs- und Regelungseinheit verlaufenden Kühlmittelleitungen sowie gegebenenfalls das Innere von Leitungen, mit denen der Brennstoffzelleneinheit Verbrennungsgas zugeführt wird bzw. Brenngase abgeführt werden. Bei der abgedichteten Ausführungsform wird eine einbaufertige Einheit ohne dem Erfordernis einer weiteren Bearbeitung bzw. Konfektionierung bereitgestellt. Es sind lediglich die elektrischen Verbindungen an den von außen zugänglichen Schnittstellen der Energieversorgungs- und Regelungseinheit (durch entsprechende Steckverbindungen) herzustellen.

Eine bevorzugte Ausführungsform zeichnet sich dadurch aus, dass die Verbindung zwischen dem Ausgang des DC/DC-Wandlers und dem Eingang des Wechselrichters eine erste Abzweigung aufweist, die mit der Antriebskreis-Schnittstelle verbunden ist. Wie bereits erwähnt wird die Antriebskreis-Schnittstelle von DC/DC-Wandler und Wechselrichter gemeinsam genutzt. Da ein Teil der Leistung direkt vom Wechselrichter verbraucht wird, wird in Richtung Antriebskreis bzw. Energiespeicher von vornherein weniger Leistung abgezweigt. Die Antriebskreis-Schnittstelle, insbesondere der entsprechende Steckerteil, kann daher wesentlich kleiner dimensioniert werden.

Eine bevorzugte Ausführungsform zeichnet sich dadurch aus, dass in der Verbindung zwischen der ersten Abzweigung und der Antriebskreis-Schnittstelle ein Filter, vorzugsweise ein EMV-Filter, geschaltet ist. Diese Ausführung ermöglicht die gemeinsame Nutzung eines Filters (d.h. durch den DC/DC-Wandler und den Wechselrichter). Wie die gemeinsame Antriebskreis-Schnittstelle kann ausdenselben Gründen auch der EMV-Filter kleiner ausfallen. Vorzugsweise ist der Filter ebenfalls innerhalb des gemeinsamen Gehäuses angeordnet. Der Filter kann zwischen der Ausgangskapazität des DC/DC-Wandlers bzw. der Eingangskapazität des Kompressormotor-Wechselrichters (diese sind zueinander parallel geschaltet) und der Antriebskreis-Schnittstelle geschaltet sein.

Eine bevorzugte Ausführungsform zeichnet sich dadurch aus, dass die Antriebskreis-Schnittstelle und die Kompressormotor-Schnittstelle von außerhalb des Gehäuses zugänglich sind und vorzugsweise an bzw. in der Außenwand des Gehäuses sitzen, wobei vorzugsweise die Antriebskreis-Schnittstelle und die Kompressormotor-Schnittstelle jeweils in Form eines Steckerteils ausgebildet sind. Die genannten Schnittstellen erlauben die elektrische Verbindung von Kompressormotor und einem vom Antriebskreis umfassten elektrischem Energiespeicher mit Komponenten innerhalb des gemeinsamen Gehäuses, d.h. sie stellen Verbindungen zwischen Gehäuseinnerem und Außenraum dar.

Eine bevorzugte Ausführungsform zeichnet sich dadurch aus, dass zwischen den Polen der Verbindung zwischen dem Ausgang des DC/DC-Wandlers und dem Eingang des Wechselrichters zumindest eine Zwischenkreiskapazität geschaltet ist. Diese Zwischenkreiskapazität ist ebenfalls im gemeinsamen Gehäuse untergebracht. Aufgrund der erfindungsgemäßen Architektur kann auch diese Zwischenkreiskapazität zur Stützung der Spannung im Zwischenkreis (d.h. zwischen DC/DC-Wandler und Wechselrichter) gemeinschaftlich genutzt werden. Das Vorsehen einer gemeinsamen Zwischenkreiskapazität wird daher bevorzugt. Diese dient der Realisierung der Ausgangskapazität des DC/DC-Wandlers und der Realisierung der Eingangskapazität des Wechselrichters. Dabei können ein gemeinsamer oder mehrere gemeinsame Kondensator(en) verwendet werden. Diese Kondensatoren bilden eine dem Wechselrichter und DC/DC-Wandler gemeine Zwischenkreiskapazität.

Eine bevorzugte Ausführungsform zeichnet sich dadurch aus, dass die Energieversorgungs- und Regelungseinheit eine Spannungsmesseinrichtung umfasst, die dazu eingerichtet ist, die Spannung zwischen den Polen der Verbindung zwischen dem Ausgang des DC/DC-Wandlers und dem Eingang des Wechselrichters zu messen. Vorzugsweise wird dabei die Spannung über einer gemeinsamen Zwischenkreiskapazität gemessen. Da der DC/DC-Wandler und der Wechselrichter denselben Zwischenkreis verwenden, ist nur eine Spannungsmessung von Nöten. Diese Spannungsmesseinrichtung ist ebenfalls im gemeinsamen Gehäuse untergebracht. Der Messwert kann z.B. als Steuergröße für Bauteile des DC/DC-Wandlers und des Wechselrichters, wie Treiber, Schalter und dgl., verwendet werden, um die Leistungsbereitstellung zu optimieren und zu regulieren. Auch hier entstehen durch die gemeinschaftliche Nutzung Vorteile, da im Gegensatz zum Stand der Technik nur eine gemeinsame Spannungsmesseinrichtung erforderlich ist. Alternativ oder zusätzlich dazu kann in der Verbindung zwischen dem Ausgang des DC/DC-Wandlers und dem Eingang des Wechselrichters eine Strommesseinrichtung geschaltet bzw. vorgesehen sein. Zur Regulierung, Limitierung und Absicherung des Systems können der Strom aus dem DC/DC-Wandler, der Strom in den Wechselrichter und der Strom zum Antriebskreis bzw. dessen Energiespeicher essentiell sein. Durch die erfindungsgemäße Konzeption kann durch Messung von lediglich zwei dieser drei Ströme, der dritte Strom durch numerische Auswertung der beiden gemessenen Ströme hochdynamisch ermittelt werden. Im Vergleich zum Stand der Technik kann hier somit eine Messung entfallen.

Eine bevorzugte Ausführungsform zeichnet sich dadurch aus, dass zumindest eine Komponente des DC/DC-Wandlers und zumindest eine Komponente des Wechselrichters von einer gemeinsamen Spannungsversorgungseinrichtung gespeist werden, wobei vorzugsweise die Spannungsversorgungseinrichtung in dem gemeinsamen Gehäuse untergebracht ist. Wiederum können dadurch - im Vergleich zu Stand der Technik - Bauteile eingespart werden. Die Energieversorgungs- und Regelungseinheit, die dem Kompressormotor Leistung bereitstellt, versorgt sich in dieser Ausführungsform selbst mit für deren Betrieb erforderlichen Energie. Im Grunde wird die Versorgung dann über die Hochvolt(HV)-Seite und nicht mehr über Niedrigvolt(LV)-Seite vorgenommen. Das gilt nicht nur für den Umrichter, sondern auch für den DC/DC-Wandler. Erzielt wird damit jedoch insbesondere die Versorgung von LV-Schaltungsteilen (z.B. Isolatoren, Optokopplern, OPVs, etc.).

Eine bevorzugte Ausführungsform zeichnet sich dadurch aus, dass die Verbindung zwischen dem Ausgang des DC/DC-Wandlers und dem Eingang des Wechselrichters eine zweite Abzweigung aufweist, die mit dem Eingang der gemeinsamen Spannungsversorgungseinrichtung verbunden ist. Die Spannungsversorgungseinrichtung wandelt die Hochvolt-Spannung des DC/DC-Wandlers um in eine andere, vorzugsweise niedrigere Spannung, die vorzugsweise um einen Faktor von zumindest 4 kleiner sein kann als die Ausgangsspannung des DC/DC-Wandlers, z.B. von einer Spannung von 400V auf 80V. Die Spannungsversorgungseinrichtung kann zumindest eine Untereinheit umfassen, die die Spannung weiter verringert. So können für unterschiedliche Komponenten unterschiedliche Versorgungsspannungen bereitgestellt werden. Z.B. können zur Versorgung unterschiedlicher Schaltungsteile von DC/DC-Wandler und Wechselrichter unterschiedliche, gemeinsam genutzte Spannungsebenen von einer gemeinsamen Spannungsversorgungseinrichtung generiert werden.

Eine bevorzugte Ausführungsform zeichnet sich dadurch aus, dass der DC/DC-Wandler und der Wechselrichter zumindest eine gemeinsame (bzw. gemeinsam genutzte) Steuereinrichtung, insbesondere einen Controller, einen FPGA, einen CPLD und/oder einen ASIC, aufweisen, die in dem gemeinsamen Gehäuse untergebracht ist. Die Ansteuerungsfunktion von DC/DC-Wandler und Wechselrichter kann dadurch ebenfalls mit einem oder mehreren gemeinsam genutzten Bauteil(en) erfolgen. Der Controller befindet sich ebenfalls innerhalb des gemeinsamen Gehäuses.

Eine bevorzugte Ausführungsform zeichnet sich dadurch aus, dass der DC/DC-Wandler und der Wechselrichter in Bezug auf die Anordnung ihrer Komponenten zumindest teilweise ineinander verflochten sind und/oder dass Komponenten des DC/DC-Wandlers und Komponenten des Wechselrichters auf einer gemeinsamen Platine sitzen. Der zur Verfügung stehende Bauraum innerhalb des Gehäuses kann dadurch optimal genutzt werden. Auch können Komponenten von DC/DC-Wandler und Wechselrichter, die eine erhöhte Kühlung erfordern, im Bereich einer Kühlmittelleitung angeordnet werden, während Komponenten ohne nennenswerte Wärmeproduktion in einem davon weiter entfernten Bereich angeordnet werden. Auch können die zu kühlenden Bauelemente, welche auf eine möglichst ideale Kühlung angewiesen sind, durch flexible Wahl der Reihenfolge, in der die Elemente gekühlt werden, mit einer niedrigeren Kühlwassertemperatur gekühlt werden. Möglichst ideal zu kühlende Bauelemente können dabei nah am Zufluss des Kühlkanals platziert werden, die Temperatur des Kühlmediums ist dort am geringsten. Unkritischere Bauelemente werden ans Ende des Kühlkreislaufes platziert. Die etwas höhere Temperatur des Kühlmediums ist dort akzeptabel. In funktioneller Hinsicht stellen DC/DC-Wandler und der Wechselrichter eigenständige Einheiten dar. Baulich sind sie jedoch vereint (miteinander 'verwoben').

Eine bevorzugte Ausführungsform zeichnet sich dadurch aus, dass der DC/DC-Wandler und der Wechselrichter eine gemeinsame Steuerschnittstelle aufweisen, die von außerhalb des Gehäuses zugänglich ist und vorzugsweise an der Außenwand des Gehäuses sitzt, wobei vorzugsweise die Steuerschnittstelle in Form eines Steckerteils ausgebildet ist. An dieser Stelle sei erwähnt, dass auch ein Gehäusedeckel als eine Außenwand des Gehäuses betrachtet wird. Es ist somit eine einzige Steuerschnittstelle erforderlich, die die Energieversorgungs- und Regeleinrichtung mit der Bordsteuerung verbindet. Die Steuerschnittstelle kann mehrere Steuerleitungen umfassen, vorzugsweise ist aber lediglich ein Steuerstecker von Nöten. Bestimmte Signale können gemeinsam genutzt werden, z.B. CAN-Bus, LV-Versorgungsleitungen (im Automobil z.B. 12V), ENABLE (im Automobil auch 'Klemme15' genannt), etc..

Eine bevorzugte Ausführungsform zeichnet sich dadurch aus, dass das gemeinsame Gehäuse eine Kühlmittelzufuhr und eine Kühlmittelabfuhr umfasst, wobei Komponenten des DC/DC-Wandlers und Komponenten des Wechselrichters und gegebenenfalls eine im gemeinsamen Gehäuse (das z.B. auch aus zwei oder mehreren Gehäuseteilen gebildet sein kann, die durch eine mechanische Verbindung, z.B. Flansch, miteinander verbunden sind und einen gemeinsamen inneren Bauraum bilden) untergebrachte Brennstoffzelleneinheit durch einen gemeinsamen Kühlmittelkreislauf gekühlt sind. Die Auslegung des Kühlsystems kann dadurch wesentlich vereinfacht und reduziert werden. Dadurch, dass es einen gemeinsamen Kühlkanal gibt, hat der Entwickler freie Wahl, die Reihenfolge der zu kühlenden Elemente (Halbleitermodule, Hauptdrosseln, Filterdrosseln) festzulegen. Falls gewünscht können alle (Schalt-)Module (jene des DC/DC-Wandlers und jene des Wechselrichters) gekühlt werden, bevor die Wickelgüter gekühlt werden. Auf diese Weise sehen die (Schalt-)Module eine geringere Kühlwassertemperatur (dies kann eine Differenz von einigen Grad ausmachen).

Auch die Messung der Kühlwassertemperatur kann somit 'gemeinsam' erfolgen. Durch die Kombination von DC/DC-Wandler und Wechselrichter in einem Gehäuse ist nur eine Messung der Kühlmitteltemperatur nötig. Im Vergleich zum Stand der Technik kann hier somit eine Messung entfallen.

Die eingangs gestellte Aufgabe wird auch gelöst durch einen Brennstoffzellenantrieb mit einem Antriebskreis, einem mit dem Antriebskreis verbundenen Antriebsmotor, insbesondere einem Traktionsmotor, einer Brennstoffzelleneinheit und einem Brennstoffzellenkompressor, der einen Kompressormotor aufweist, gekennzeichnet durch eine Energieversorgungs- und Regelungseinheit, insbesondere nach einer der vorhergehenden Ausführungsformen, wobei der Antriebskreis mit der Antriebskreis-Schnittstelle der Energieversorgungs- und Regelungseinheit und der Kompressormotor mit der Kompressormotor-Schnittstelle der Energieversorgungs- und Regelungseinheit und die Brennstoffzelleneinheit mit der Brennstoffzellen-Eingangsschnittstelle des DC/DC-Wandlers verbunden ist.

An dieser Stelle wird ausdrücklich erwähnt, dass die obige Bezeichnung 'Antriebsmotor' nicht den Kompressormotor umfasst und die Bezeichnung 'Antriebskreis' nicht der Versorgung des Kompressormotors dient, sondern der Versorgung des Antriebsmotors. Der Antriebsmotor dient zum Antreiben eines Fahrzeuges oder einer Maschine und ist daher insbesondere ein Traktionsmotor. Der Antriebsmotor wird aber ebenso wie der Kompressormotor über die Energieversorgungs- und Regelungseinheit bestromt.

Die eingangs erwähnte Aufgabe wird auch mit einem Brennstoffzellenfahrzeug mit einem Antriebskreis, einem mit dem Antriebskreis verbundenen Antriebsmotor (Traktionsmotor), einer Brennstoffzelleneinheit, einem Brennstoffzellenkompressor und vorzugsweise einem elektrischen Energiespeicher, insbesondere einer Batterie, gelöst durch eine Energieversorgungs- und Regelungseinheit nach einer der vorhergehenden Ausführungsformen, wobei der Kompressormotor mit der Kompressormotor-Schnittstelle der Energieversorgungs- und Regelungseinheit und der Antriebskreis mit der Antriebskreis-Schnittstelle der Energieversorgungs- und Regelungseinheit verbunden ist. Der Antriebs- bzw. Traktionsmotor ist dabei über die Energieversorgungs- und Regelungseinheit mit der Brennstoffzelleneinheit verbunden. Wie bereits erwähnt umfasst der Antriebskreis auch einen Traktionsumrichter. An dieser Stelle sei erwähnt, dass durchaus Konzepte denkbar sind, bei denen der Antriebskreis ohne Energiespeicher auskommt (dieser somit nicht zwingend ist).

Das Brennstoffzellenfahrzeug umfasst somit einen Kompressor, insbesondere einen Turbo-Kompressor, zur Verdichtung des Verbrennungsgases für die Brennstoffzelleneinheit. Unter Verbrennungsgas wird jenes Gas verstanden, das der Kathode der Brennstoffzelle zugeführt wird. Wenn die Brennstoffzelleneinheit ebenfalls in der Energieversorgungs- und Regelungseinheit untergebracht ist, umfasst das gemeinsame Gehäuse eine Verbrennungsgaszufuhrschnittstelle, die mit dem Kompressor verbunden ist. Diese weitere Schnittstelle der Energieversorgungs- und Regelungseinheit führt in das Innere der Brennstoffzelleneinheit.

Eine Ausführungsvariante zeichnet sich dadurch aus, dass die Energieversorgungs- und Regelungseinheit direkt an das Gehäuse der Brennstoffzelleneinheit angebracht wird (z.B. per Flansch) und eine unmittelbare Verbindung ohne Kabel o.ä. realisiert wird.

Bei der Brennstoffzelleneinheit handelt es sich um mehrere Einzelzellen, auch Stack (Stapel von Einzelzellen) genannt. Wie bei den Zellen einer konventionellen HV-Batterie, addieren sich die Spannungen der Einzelzellen bei dem seriellen Verschalten zu einem Stack. Die normalerweise generierte Spannung einer einzelnen Brennstoffzelle kann dabei z.B. im Bereich von 0.6V - 0.9V liegen und/oder kann die Brennstoffzelle eine theoretische Maximalspannung von 1.23V aufweisen.

Im Folgenden werden wichtige Vorteile von Varianten der Erfindung nochmals zusammengefasst: Gemeinsame Zwischenkreiskapazitäten, gemeinsames EMV-Filter, gemeinsamer Hochvolt-Stecker (Antriebskreis-Schnittstelle), gemeinsamer Steuer-Stecker, gemeinsame Messungen (Temperatur, Spannung, Strom), gemeinsame Spannungsversorgung von DC/DC-Wandler und Wechselrichter (zum Versorgen von Komponenten, insbesondere zum weichen Schalten der Halbleiterschalter), gemeinsame Niedrigvolt-Schaltungsteile (5V-Speisung, etc.) und gegebenenfalls zumindest eine gemeinsame Steuereinrichtung, insbesondere ein Controller und/oder FPGA (Field Programmable Gate Array) und/oder CPLD (Complex Programmable Logic Device) und/oder ASIC (Application-specific integrated circuit).

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind. Dabei können die in den Ansprüchen und in der Beschreibung erwähnten Merkmale jeweils einzeln für sich oder in beliebiger Kombination erfindungswesentlich sein.

Die Bezugszeichenliste ist Bestandteil der Offenbarung. Die Figuren werden zusammenhängend und übergreifend beschrieben. Gleiche Bezugszeichen bedeuten gleiche Bauteile, Bezugszeichen mit unterschiedlichen Indices geben funktionsgleiche oder ähnliche Bauteile an.

Es zeigen dabei:
- Fig. 1: eine erste Ausführungsform einer erfindungsgemässen Energieversorgungs- und Regelungseinheit,
- Fig. 2: eine zweite Ausführungsform einer Energieversorgungs- und Regelungseinheit,
- Fig. 3: eine Energieversorgungs- und Regelungseinheit mit Kühlmittelkreis,
- Fig. 4: eine schematische Anordnung von Komponenten des DC/DC-Wandlers und des Wechselrichters., und
- Fig. 5: ein Brennstoffzellenfahrzeug.

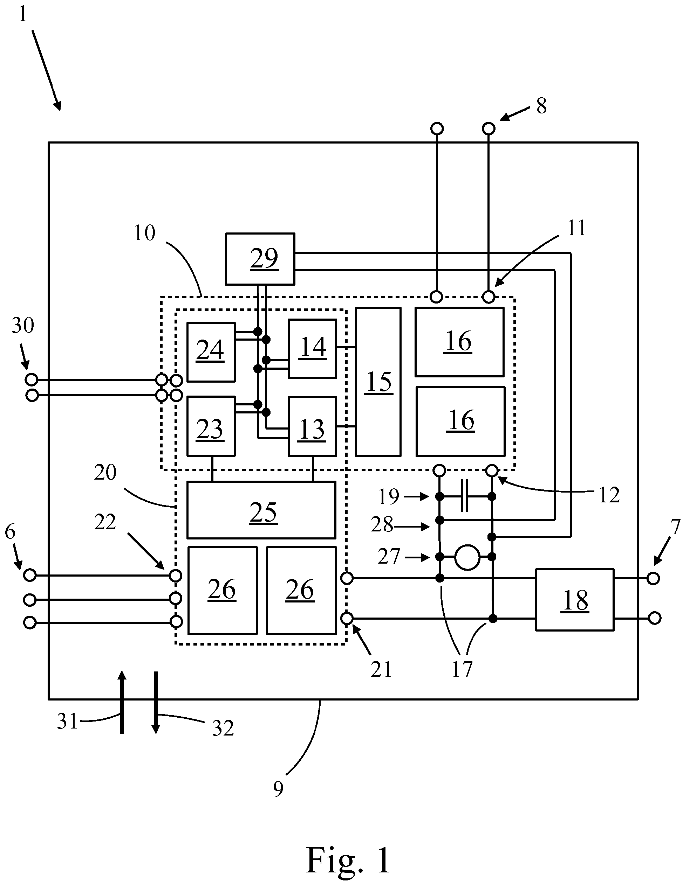

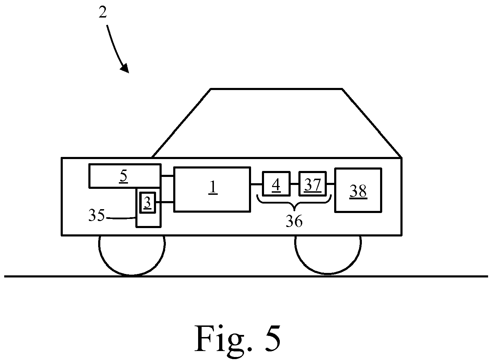

Fig. 1 zeigt eine Energieversorgungs- und Regelungseinheit 1 für ein Brennstoffzellenfahrzeug 2. Diese umfasst einen DC/DC-Wandler 10 mit einer Brennstoffzellen-Eingangsschnittstelle 11, einen Wechselrichter 20, eine Antriebskreis-Schnittstelle 7 zum Anschluss an einen Antriebskreis 36, insbesondere an einen elektrischen Energiespeicher 4 des Antriebskreises 36 (Fig. 5), und eine Kompressormotor-Schnittstelle 6 zum Anschluss an einen Kompressormotor 3 des Brennstoffzellenfahrzeuges.

Der Ausgang 12 des DC/DC-Wandlers 10 ist mit dem Eingang 21 des Wechselrichters 20 verbunden. Der Ausgang 22 des Wechselrichters 20 ist mit der Kompressormotor-Schnittstelle 6 verbunden. Der DC/DC-Wandler 10 und der Wechselrichter 20 sind in einem gemeinsamen Gehäuse 9 untergebracht. Das gemeinsame Gehäuse 9 ist wasserdicht abgeschlossen, sodass die elektrischen Bauteile und deren Verbindungen im Hinblick auf Feuchtigkeit hermetisch abgeschlossen sind. Vorzugsweise umfasst das gemeinsame Gehäuse 9 eine Druckausgleichsmembran zum Ausgleich von Druckdifferenzen.

Der Gleichspannungswandler 10 ist dazu eingerichtet, die Ausgangsspannung einer mit dem DC/DC-Wandler 10 verbundenen Brennstoffzelleneinheit zu konvertieren, insbesondere hochzusetzen, und in einem Zwischenkreis bereitzustellen. Der DC/DC-Wandler 10 umfasst zumindest ein Schaltelement, insbesondere mehrere zu einem Schaltmodul 15 zusammengefasste Schaltelemente. Die Schaltelemente sind Halbleiterschaltelemente, z.B. IGBTs, und werden nach einem vorgegebenen Muster geschaltet, um die Gleichspannung zu zerteilen. Der DC/DC-Wandler 10 umfasst weiters Leistungskomponenten 16, die elektrische Energiespeicher, insbesondere in Form von Induktivitäten (z.B. Spulen und/oder Transformatoren) und Kondensatoren, darstellen. Diese bilden einen Gleichrichter, um die von dem Schaltmodul 15 zerhackte Spannung wieder zu glätten. Der DC/DC-Wandler 10 umfasst auch Steuerungskomponenten, die insbesondere für die Ansteuerung des Schaltmoduls 15 vorgesehen sind, z.B. einen Controller 13 und/oder Treiber 14, insbesondere für die Schaltvorgänge des Schaltmoduls.

Der Wechselrichter 20 (bzw. Inverter) ist dazu eingerichtet, aus der am Zwischenkreis anliegenden Gleichspannung eine vorzugsweise 3-phasige Wechselspannung zur Speisung des Brennstoffzellenkompressormotors 3 zu erzeugen. Der Wechselrichter 20 umfasst ein Schaltmodul 25 aus Halbleiterschaltelementen, z.B. IGBTs, sowie Leistungskomponenten 26, die elektrische Energiespeicher, insbesondere in Form von Induktivitäten (z.B. Spulen und/oder Transformatoren) und Kondensatoren, darstellen. Der Wechselrichter 20 umfasst auch Steuerungskomponenten, die insbesondere für die Ansteuerung des Schaltmoduls 25 vorgesehen sind, z.B. eine Steuereinrichtung 13 und/oder Treiber 23, 24, insbesondere für die Schaltvorgänge des Schaltmoduls. Selbstverständlich können DC/DC-Wandler 10 und Wechselrichter 20 weitere (nicht dargestellte) Elemente wie Dioden, Widerstände, interne Sensoren, usw. umfassen.

Fig. 1 zeigt auch eine von außerhalb des Gehäuses 9 zugängliche Brennstoffzellen-Schnittstelle 8 zum Anschluss an eine Brennstoffzelleneinheit 5. Diese ist mit der Brennstoffzellen-Eingangsschnittstelle 11 des DC/DC-Wandlers 10 verbunden.

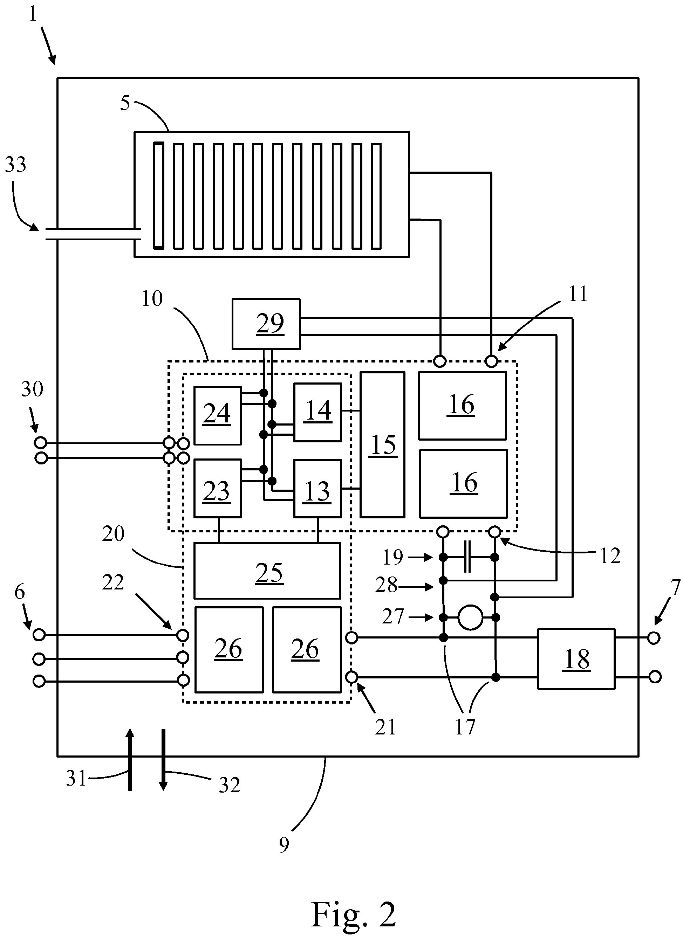

Fig. 2 zeigt eine besonders bevorzugte Variante, bei der die Energieversorgungs- und Regelungseinheit 1 bereits eine Brennstoffzelleneinheit 5 mitumfasst, die mit der Brennstoffzellen-Eingangsschnittstelle 11 des DC/DC-Wandlers 10 verbunden ist und in demselben Gehäuse 9 untergebracht ist wie der DC/DC-Wandler 10 und der Wechselrichter 20. Die Gehäusewand ist hier durch eine Verbrennungsgaszufuhrschnittstelle 33 (z.B. mit komprimierter Luft) durchbrochen, die in das Innere der Brennstoffzelleneinheit 5 mündet. Schnittstellen für die Bereitstellung des Brennstoffes (Wasserstoff) und die Abfuhr von Wasser (Verbrennungsprodukt) sind ebenfalls vorhanden (der Übersichtlichkeit halber aber nicht dargestellt).

Die Verbindung zwischen dem Ausgang 12 des DC/DC-Wandlers 10 und dem Eingang 21 des Wechselrichters 20 weist eine erste Abzweigung 17 (bzw. Knoten) auf, die mit der Antriebskreis-Schnittstelle 7 verbunden ist. In der Verbindung zwischen der ersten Abzweigung 17 und der Antriebskreis-Schnittstelle 7 kann ein Filter 18, vorzugsweise ein EMV-Filter, geschaltet sein. Das Filter 18 stellt ein gemeinsames Filter für DC/DC-wandler und Wechselrichter 20 in Richtung Antriebskreis 36 bzw. Energiespeicher 4 dar (Fig. 5).

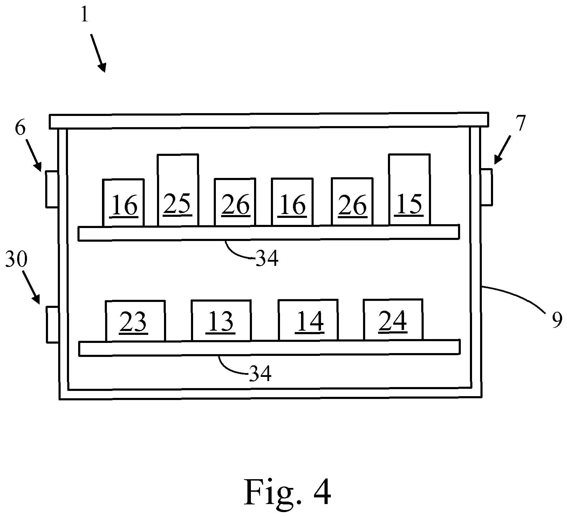

Die Antriebskreis-Schnittstelle 7 und die Kompressormotor-Schnittstelle 6 sind - wie dies auch in der Ausführungsform von Fig. 4 zu sehen ist - von außerhalb des Gehäuses 9 zugänglich. Sie können an oder in der Außenwand des Gehäuses 9 sitzen und jeweils in Form eines Steckerteils ausgebildet sein.

Zwischen den Polen der Verbindung zwischen dem Ausgang 12 des DC/DC-Wandlers 10 und dem Eingang 21 des Wechselrichters 20 kann zumindest eine Zwischenkreiskapazität 19 geschaltet sein.

Die Energieversorgungs- und Regelungseinheit 1 kann weiters eine Spannungsmesseinrichtung 27 umfassen, die dazu eingerichtet ist, die Spannung zwischen den Polen der Verbindung zwischen dem Ausgang 12 des DC/DC-Wandlers 10 und dem Eingang 21 des Wechselrichters 20 (d.h. im Zwischenkreis) zu messen.

In den in Fig. 1 und 2 dargestellten Ausführungsformen werden zumindest eine Komponente 13, 14 des DC/DC-Wandlers 10 und zumindest eine Komponente 13, 23, 24 des Wechselrichters 20 von einer gemeinsamen Spannungsversorgungseinrichtung 29 gespeist. Die Spannungsversorgungseinrichtung 29 ist in dem gemeinsamen Gehäuse 9 untergebracht. Die Verbindung (bzw. der Zwischenkreis) zwischen dem Ausgang 12 des DC/DC-Wandlers 10 und dem Eingang des Wechselrichters 21 weist dazu eine zweite Abzweigung 28 auf, die mit dem Eingang der gemeinsamen Spannungsversorgungseinrichtung 29 verbunden ist. Die Energieversorgungs- und Regelungseinheit 1 versorgt sich somit selbst mit für deren Betrieb erforderlichen Energie.

Wie anhand der schematischen Darstellung der Fig. 1 und 2 bereits ersichtlich ist die Steuereinrichtung 13 sowohl dem er DC/DC-Wandler 10, als auch dem Wechselrichter 20 zugeordnet, d.h. DC/DC-Wandler 10 und Wechselrichter 20 weisen eine gemeinsame (bzw. gemeinsam genutzten) Steuereinrichtung 13 auf.

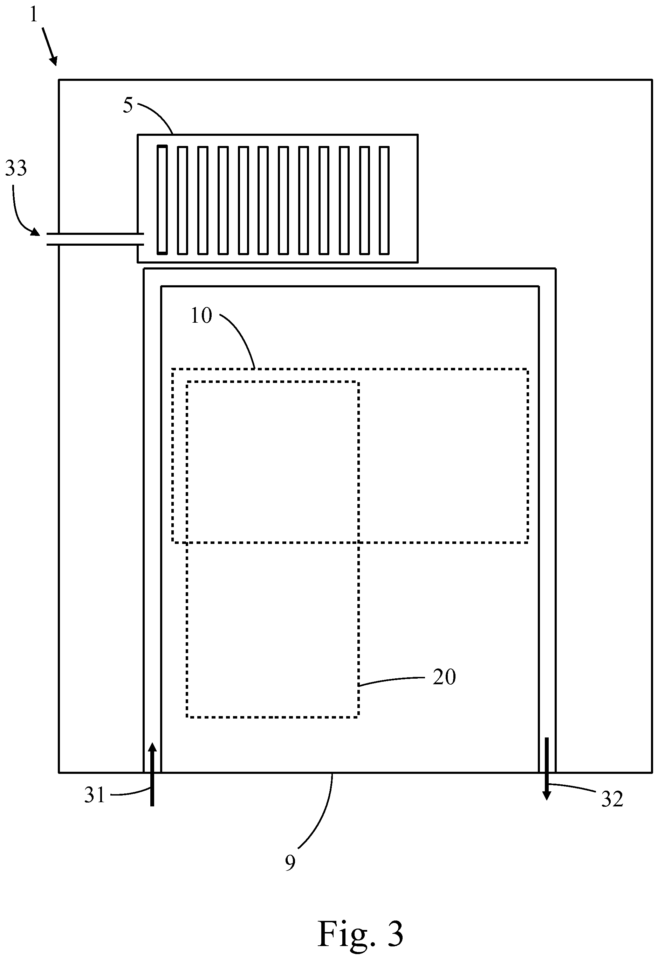

Fig. 1 und 2 deuten durch die strichlierte Darstellung bereits an, dass der DC/DC-Wandler 10 und der Wechselrichter 20 in Bezug auf die Anordnung ihrer Komponenten zumindest teilweise ineinander verflochten sind bzw. überlappen. So können Komponenten 13, 14, 15, 16 des DC/DC-Wandlers 10 und Komponenten 13, 23, 24, 25, 26 des Wechselrichters 20 auf einer gemeinsamen Platine sitzen (Fig. 3).

Aus Fig. 1, 2 und 4 geht hervor, dass der DC/DC-Wandler 10 und der Wechselrichter 20 eine gemeinsame Steuerschnittstelle 30 aufweisen, die von außerhalb des Gehäuses 9 zugänglich ist und vorzugsweise an oder in der Außenwand des Gehäuses 9 sitzt (Fig. 4) und in Form eines Steckerteils ausgebildet sind.

Das gemeinsame Gehäuse 9 umfasst auch eine Kühlmittelzufuhr 31 und eine Kühlmittelabfuhr 32 umfasst, die die Enden eines im Gehäuse verlaufenden Kühlmittelkreises bilden. Dabei werden gemäß Ausführungsform von Fig. 3 Komponenten des DC/DC-Wandlers 10 und Komponenten des Wechselrichters 20 und gegebenenfalls eine im gemeinsamen Gehäuse 9 untergebrachte Brennstoffzelleneinheit 5 durch einen gemeinsamen Kühlmittelkreislauf gekühlt.

Fig. 5 zeigt schließlich einen erfindungsgemäßen Brennstoffzellenantrieb mit einem Antriebskreis 36, einem an den Antriebskreis 36 angebundenen Antriebsmotor 38 (bzw. Traktionsmotor), einer Brennstoffzelleneinheit 5 und einem Brennstoffzellenkompressor 35, der einen Kompressormotor 3 aufweist. Die Energieversorgungs- und Regelungseinheit 1 ist mit dem Kompressormotor 3 über deren Kompressormotor-Schnittstelle 6 verbunden. Die Brennstoffzelleneinheit 5 ist mit der Brennstoffzellen-Schnittstelle 8 (Fig. 1) bzw. über die Brennstoffzellen-Eingangsschnittstelle 11 (Fig. 1 und 2) mit dem DC/DC-Wandler 10 verbunden. Der Antriebsmotor 38 wird ebenfalls über die Energieversorgungs- und Regelungseinheit 1 bestromt. Der die Einheit 1 mit dem Antriebsmotor 38 verbindende Antriebskreis 36 umfasst einen elektrischen Energiespeicher 4 und einen Antriebsumrichter 37 bzw. Traktionsumrichter zur Umwandlung der Gleichspannung in eine vorzugsweise 3-phasige Wechselspannung.

Das Brennstoffzellenfahrzeug 2 weist einen elektrischen Energiespeicher 4, insbesondere eine Batterie, auf. Der elektrische Energiespeicher 4 ist mit der Antriebskreis-Schnittstelle 7 der Energieversorgungs- und Regelungseinheit 1 verbunden. Das Brennstoffzellenfahrzeug 2 umfasst auch einen Brennstofftank (Wasserstofftank) sowie eine Wasserabfuhr (Verbrennungsprodukt), die jeweils in der Brennstoffzelleneinheit 5 münden (nicht dargestellt).

In der dargestellten bevorzugten Ausführungsform umfasst das Brennstoffzellenfahrzeug 2 einen Brennstoffzellenkompressor 35, insbesondere einen Turbo-Kompressor, zur Verdichtung der Verbrennungsluft für die Brennstoffzelleneinheit 5. Wenn die Brennstoffzelleneinheit 5 ebenfalls in der Energieversorgungs- und Regelungseinheit 1 untergebracht wäre (Fig. 2), umfasst das gemeinsame Gehäuse 9 eine Verbrennungsgaszufuhr 33, die mit dem Brennstoffzellenkompressor 35 verbunden ist. Diese weitere Schnittstelle der Energieversorgungs- und Regelungseinheit 1 führt in das Innere der Brennstoffzelleneinheit 5. Die Brennstoffzelleneinheit 5 ist gemäß Fig. 5 außerhalb des gemeinsamen Gehäuses 9 der Energieversorgungs- und Regelungseinheit 1 und somit als gesonderte bauliche Einheit angeordnet; kann aber wie gesagt auch im Inneren des Gehäuses 9 untergebracht sein.

Bei der Brennstoffzelleneinheit 5 handelt es sich um eine Anordnung bzw. einen Stack (bzw. Stapel) von Einzelzellen. Diese sind seriell miteinander verschaltet, sodass sich die Einzelspannungen addieren. Die Spannung einer einzelnen Brennstoffzelle kann z.B. im Bereich von 0.6V - 0.9V liegen. Die Ausgangsspannung der gesamten Brennstoffzelleneinheit 5 kann z.B. je nach Ausgangsstrom zwischen 60V und 110V betragen.

Die Erfindung ist nicht auf die beschriebenen Ausführungsformen und die darin hervorgehobenen Aspekte beschränkt. Vielmehr ist innerhalb des Erfindungsgedankens eine Vielzahl von Abwandlungen möglich, die im Rahmen fachmännischen Handelns liegen. Ebenso ist es möglich, durch Kombination der genannten Mittel und Merkmale weitere Ausführungsvarianten zu realisieren, ohne den Rahmen der Erfindung zu verlassen.

### Bezugszeichenliste

- 1: Energieversorgungs- und Regelungseinheit
- 2: Brennstoffzellenfahrzeug
- 3: Kompressormotor
- 4: Elektrischer Energiespeicher
- 5: Brennstoffzelleneinheit
- 6: Kompressormotor-Schnittstelle
- 7: Antriebskreis-Schnittstelle
- 8: Brennstoffzellen-Schnittstelle
- 9: Gehäuse
- 10: DC/DC-Wandler
- 11: Brennstoffzellen-Eingangsschnittstelle
- 12: Ausgang des DC/DC-Wandlers
- 13: Steuereinrichtung
- 14: Steuerkomponente, z.B. Treiber
- 15: Schaltmodul
- 16: Leistungskomponente, z.B. Induktivität oder Kondensator
- 17: erste Abzweigung
- 18: Filter
- 19: Zwischenkreiskapazität
- 20: Wechselrichter
- 21: Eingang des Wechselrichters
- 22: Ausgang des Wechselrichters
- 23: Steuerkomponente, z.B. Treiber oder Controller
- 24: Steuerkomponente, z.B. Treiber
- 25: Schaltmodul
- 26: Leistungskomponente, z.B. Induktivität oder Kondensator
- 27: Spannungsmesseinrichtung
- 28: zweite Abzweigung
- 29: Spannungsversorgungseinrichtung
- 30: Steuerschnittstelle
- 31: Kühlmittelzufuhr
- 32: Kühlmittelabfuhr
- 33: Verbrennungsgaszufuhrschnittstelle
- 34: Platine
- 35: Brennstoffzellenkompressor
- 36: Antriebskreis
- 37: Antriebsumrichter bzw. Traktionsumrichter
- 38: Antriebsmotor bzw. Traktionsmotor

## Patentansprüche

1. Energieversorgungs- und Regelungseinheit (1) zur Versorgung eines Antriebskreises, insbesondere eines Traktionsantriebskreises, und eines Brennstoffzellenkompressors über gesonderte Schnittstellen (6, 7), umfassend:
- einen DC/DC-Wandler (10) mit einer Brennstoffzellen-Eingangsschnittstelle (11),
- einen Wechselrichter (20),
- eine Antriebskreis-Schnittstelle (7) zum Anschluss an einen Antriebskreis (36), und
- eine Kompressormotor-Schnittstelle (6) zum Anschluss an einen Kompressormotor (3) eines Brennstoffzellenkompressors,
wobei der Ausgang (12) des DC/DC-Wandlers (10) mit dem Eingang (21) des Wechselrichters (20) und mit der Antriebskreis-Schnittstelle (7) verbunden ist, und wobei der Ausgang (22) des Wechselrichters (20) mit der Kompressormotor-Schnittstelle (6) verbunden ist, **dadurch gekennzeichnet dass** der DC/DC-Wandler (10) und der Wechselrichter (20) in einem gemeinsamen Gehäuse (9) untergebracht sind.

2. Energieversorgungs- und Regelungseinheit nach Anspruch 1, **dadurch gekennzeichnet, dass** die Energieversorgungs- und Regelungseinheit (1) eine Brennstoffzelleneinheit (5) umfasst, die mit der Brennstoffzellen-Eingangsschnittstelle (11) des DC/DC-Wandlers (10) verbunden ist und in demselben Gehäuse (9) untergebracht ist wie der DC/DC-Wandler (10) und der Wechselrichter (20).

3. Energieversorgungs- und Regelungseinheit nach Anspruch 1 oder 2, **dadurch gekennzeichnet, dass** das gemeinsame Gehäuse (9) wasserdicht, vorzugsweise auch luftdicht, abgeschlossen ist.

4. Energieversorgungs- und Regelungseinheit nach einem der vorhergehenden Ansprüche, **dadurch gekennzeichnet, dass** die Verbindung zwischen dem Ausgang (12) des DC/DC-Wandlers (10) und dem Eingang (21) des Wechselrichters (20) eine erste Abzweigung (17) aufweist, die mit der Antriebskreis-Schnittstelle (7) verbunden ist.

5. Energieversorgungs- und Regelungseinheit nach Anspruch 4, **dadurch gekennzeichnet, dass** in der Verbindung zwischen der ersten Abzweigung (17) und der Antriebskreis-Schnittstelle (7) ein Filter (18), vorzugsweise ein EMV-Filter, geschaltet ist.

6. Energieversorgungs- und Regelungseinheit nach einem der vorhergehenden Ansprüche, **dadurch gekennzeichnet, dass** die Antriebskreis-Schnittstelle (7) und die Kompressormotor-Schnittstelle (6) von außerhalb des Gehäuses (9) zugänglich sind und vorzugsweise an oder in der Außenwand des Gehäuses (9) sitzen, wobei vorzugsweise die Antriebskreis-Schnittstelle (7) und die Kompressormotor-Schnittstelle (6) jeweils in Form eines Steckerteils ausgebildet sind.

7. Energieversorgungs- und Regelungseinheit nach einem der vorhergehenden Ansprüche, **dadurch gekennzeichnet, dass** zwischen den Polen der Verbindung zwischen dem Ausgang (12) des DC/DC-Wandlers (10) und dem Eingang (21) des Wechselrichters (20) zumindest eine Zwischenkreiskapazität (19) geschaltet ist.

8. Energieversorgungs- und Regelungseinheit nach einem der vorhergehenden Ansprüche, **dadurch gekennzeichnet, dass** die Energieversorgungs- und Regelungseinheit (1) eine Spannungsmesseinrichtung (27) umfasst, die dazu eingerichtet ist, die Spannung zwischen den Polen der Verbindung zwischen dem Ausgang (12) des DC/DC-Wandlers (10) und dem Eingang (21) des Wechselrichters (20) zu messen.

9. Energieversorgungs- und Regelungseinheit nach einem der vorhergehenden Ansprüche, **dadurch gekennzeichnet, dass** zumindest eine Komponente (13, 14) des DC/DC-Wandlers (10) und zumindest eine Komponente (13, 23, 24) des Wechselrichters (20) von einer gemeinsamen Spannungsversorgungseinrichtung (29) gespeist werden, wobei vorzugsweise die Spannungsversorgungseinrichtung (29) in dem gemeinsamen Gehäuse (9) untergebracht ist.

10. Energieversorgungs- und Regelungseinheit nach Anspruch 9, **dadurch gekennzeichnet, dass** die Verbindung zwischen dem Ausgang (12) des DC/DC-Wandlers (10) und dem Eingang des Wechselrichters (21) eine zweite Abzweigung (28) aufweist, die mit dem Eingang der gemeinsamen Spannungsversorgungseinrichtung (29) verbunden ist.

11. Energieversorgungs- und Regelungseinheit nach einem der vorhergehenden Ansprüche, **dadurch gekennzeichnet, dass** der DC/DC-Wandler (10) und der Wechselrichter (20) zumindest eine gemeinsame Steuereinrichtung (13), insbesondere einen Controller (13), einen FPGA, einen CPLD und/oder einen ASIC, aufweisen, die in dem gemeinsamen Gehäuse (9) untergebracht ist.

12. Energieversorgungs- und Regelungseinheit nach einem der vorhergehenden Ansprüche, **dadurch gekennzeichnet, dass** der DC/DC-Wandler (10) und der Wechselrichter (20) in Bezug auf die Anordnung ihrer Komponenten zumindest teilweise ineinander verflochten sind **und/oder dass** Komponenten (13, 14, 15, 16) des DC/DC-Wandlers (10) und Komponenten (13, 23, 24, 25, 26) des Wechselrichters (20) auf einer gemeinsamen Platine (34) sitzen.

13. Energieversorgungs- und Regelungseinheit nach einem der vorhergehenden Ansprüche, **dadurch gekennzeichnet, dass** der DC/DC-Wandler (10) und der Wechselrichter (20) eine gemeinsame Steuerschnittstelle (30) aufweisen, die von außerhalb des Gehäuses (9) zugänglich ist und vorzugsweise an oder in der Außenwand des Gehäuses (9) sitzt, wobei vorzugsweise die Steuerschnittstelle (30) in Form eines Steckerteils ausgebildet sind.

14. Energieversorgungs- und Regelungseinheit nach einem der vorhergehenden Ansprüche, **dadurch gekennzeichnet, dass** das gemeinsame Gehäuse (9) eine Kühlmittelzufuhr (31) und eine Kühlmittelabfuhr (32) umfasst, wobei Komponenten des DC/DC-Wandlers (10) und Komponenten des Wechselrichters (20) und gegebenenfalls eine im gemeinsamen Gehäuse untergebrachte Brennstoffzelleneinheit (5) durch einen gemeinsamen Kühlmittelkreislauf gekühlt sind.

15. Brennstoffzellenantrieb mit einem Antriebskreis (36), einem mit dem Antriebskreis (36) verbundenen Antriebsmotor (38), insbesondere einem Traktionsmotor, einer Brennstoffzelleneinheit (5) und einem Brennstoffzellenkompressor (35), der einen Kompressormotor (3) aufweist, **gekennzeichnet durch** eine Energieversorgungs- und Regelungseinheit (1) nach einem der vorhergehenden Ansprüche, wobei der Antriebskreis (36) mit der Antriebskreis-Schnittstelle (7) der Energieversorgungs- und Regelungseinheit (1) und der Kompressormotor (3) mit der Kompressormotor-Schnittstelle (6) der Energieversorgungs- und Regelungseinheit (1) und die Brennstoffzelleneinheit (5) mit der Brennstoffzellen-Eingangsschnittstelle (11) des DC/DC-Wandlers (10) verbunden ist.

16. Brennstoffzellenfahrzeug (2) mit einem Brennstoffzellenantrieb nach Anspruch 15.

## Claims

1. An energy supply and control unit (1) for purposes of supplying a drive circuit, in particular a traction drive circuit, and a fuel cell compressor by way of separate interfaces (6, 7), comprising:
- a DC/DC converter (10) with a fuel cell input interface (11),
- a power inverter (20),
- a drive circuit interface (7) for purposes of connecting to a drive circuit (36), and
- a compressor motor interface (6) for purposes of connecting to a compressor motor (3) of a fuel cell compressor, wherein
the output (12) of the DC/DC converter (10) is connected with the input (21) of the power inverter (20) and with the drive circuit interface (7), and wherein
the output (22) of the power inverter (20) is connected with the compressor motor interface (6),
**characterised in that**
the DC/DC converter (10) and the power inverter (20) are accommodated in a common housing (9).

2. The energy supply and control unit in accordance with claim 1, **characterised in that**, the energy supply and control unit (1) comprises a fuel cell unit (5), which is connected with the fuel cell input interface (11) of the DC/DC converter (10) and is accommodated in the same housing (9) as the DC/DC converter (10) and the power inverter (20).

3. The energy supply and control unit in accordance with claim 1 or 2, **characterised in that**, the common housing (9) is sealed so as to be watertight, and preferably also airtight.

4. The energy supply and control unit in accordance with one of the preceding claims, **characterised in that**, the connection between the output (12) of the DC/DC converter (10) and the input (21) of the power inverter (20) has a first branch (17), which is connected with the drive circuit interface (7).

5. The energy supply and control unit in accordance with claim 4, **characterised in that**, a filter, preferably an EMC filter, is connected into the circuit connecting the first branch (17) and the drive circuit interface (7).

6. The energy supply and control unit in accordance with one of the preceding claims, **characterised in that**, the drive circuit interface (7) and the compressor motor interface (6) can be accessed from outside the housing (9), and preferably sit on or in the outer wall of the housing (9), wherein the drive circuit interface (7) and the compressor motor interface (6) are in each case preferably designed in the form of a plug-in component.

7. The energy supply and control unit in accordance with one of the preceding claims, **characterised in that**, at least one intermediate circuit capacitance (19) is connected into the circuit between the poles of the connection between the output (12) of the DC/DC converter (10) and the input (21) of the power inverter (20).

8. The energy supply and control unit in accordance with one of the preceding claims, **characterised in that**, the energy supply and control unit (1) comprises a voltage measurement device (27), which is equipped for the purpose of measuring the voltage between the poles of the connection between the output (12) of the DC/DC converter (10) and the input (21) of the power inverter (20).

9. The energy supply and control unit in accordance with one of the preceding claims, **characterised in that**, at least one component (13, 14) of the DC/DC converter (10) and at least one component (13, 23, 24) of the power inverter (20) are fed from a common voltage supply device (29), wherein the voltage supply device (29) is preferably accommodated in the common housing (9).

10. The energy supply and control unit in accordance with claim 9, **characterised in that**, the connection between the output (12) of the DC/DC converter (10) and the input of the power inverter (21) has a second branch (28), which is connected with the input of the common voltage supply device (29).

11. The energy supply and control unit in accordance with one of the preceding claims, **characterised in that**, the DC/DC converter (10) and the power inverter (20) have at least one common control device (13), in particular a controller (13), an FPGA, a GPLD and/or an ASIG, which is accommodated in the common housing (9).

12. The energy supply and control unit in accordance with one of the preceding claims, **characterised in that**, the DC/DC converter (10) and the power inverter (20) with reference to the arrangement of their components are at least partially interlinked with one another, and/or **in that** components (13, 14, 15, 16) of the DC/DC converter (10) and components (13, 23, 24, 25, 26) of the power inverter (20) sit on a common board (34).

13. The energy supply and control unit in accordance with one of the preceding claims, **characterised in that**, the DC/DC converter (10) and the power inverter (20) have a common control interface (30), which can be accessed from outside the housing (9), and preferably sits on or in the outer wall of the housing (9), wherein the control interface (30) is preferably designed in the form of a plug-in component.

14. The energy supply and control unit in accordance with one of the preceding claims, **characterised in that**, the common housing (9) comprises a coolant supply (32) and a coolant discharge (32), wherein components of the DC/DC converter (10) and components of the power inverter (20), and, if specified, a fuel cell unit (5) accommodated in the common housing, are cooled by a common coolant circuit.

15. A fuel cell drive with a drive circuit (36), a drive motor (38) connected with the drive circuit (36), in particular a traction motor, a fuel cell unit (5), and a fuel cell compressor (35), which has a compressor motor (3), **characterised by** an energy supply and control unit (1) in accordance with one of the preceding claims, wherein the drive circuit (36) is connected with the drive circuit interface (7) of the energy supply and control unit (1), and the compressor motor (3) is connected with the compressor motor interface (6) of the energy supply and control unit (1), and the fuel cell unit (5) is connected with the fuel cell input interface (11) of the DC/DC converter (10).

16. A fuel cell vehicle (2) with a fuel cell drive in accordance with claim 15.

## Revendications

1. Unité de régulation et d'alimentation en énergie (1) pour alimenter un circuit d'entraînement, notamment un circuit d'entraînement de traction et un compresseur de pile à combustible par l'intermédiaire d'interfaces spéciales (6,7), comprenant :
- un convertisseur CC/CC (10) comportant une interface d'entrée de pile à combustible (11),
- un onduleur (20),
- une interface de circuit d'entraînement (7) pour le raccordement à un circuit d'entraînement (36), et
- une interface de moteur de compresseur (6) pour le raccordement à un moteur de compresseur (3)d'un compresseur de pile à combustible,
dans laquelle la sortie (12) du convertisseur CC/CC (10) est reliée avec l'entrée (21) de l'onduleur (20) et avec l'interface de circuit d'entraînement (7), et dans laquelle la sortie (22) de l'onduleur (20) est reliée avec l'interface de moteur de compresseur (6), **caractérisée en ce que** le convertisseur CC/CC (10) et l'onduleur (20) sont renfermés dans un logement commun (9).

2. Unité de régulation et d'alimentation en énergie (1) selon la revendication 1, **caractérisée en ce que** l'unité de régulation et d'alimentation en énergie (1) comprend une unité de pile à combustible (5), qui est reliée avec l'interface d'entrée de pile à combustible (11) du convertisseur CC/CC (10) et est renfermée dans le même logement (9) que le convertisseur CC/CC (10) et l'onduleur (20).

3. Unité de régulation et d'alimentation en énergie (1) selon la revendication 1 ou 2, **caractérisée en ce que** le logement commun (9) est isolé de manière étanche à l'eau, de préférence aussi étanche à l'air.

4. Unité de régulation et d'alimentation en énergie (1) selon une des revendications précédentes, **caractérisée en ce que** la liaison entre la sortie (12) du convertisseur CC/CC (10) et l'entrée (21) de l'onduleur (20) présente un premier embranchement (17), qui est relié avec l'interface de circuit d'entraînement (7).

5. Unité de régulation et d'alimentation en énergie (1) selon la revendication 4, **caractérisée en ce que** dans la liaison entre le premier embranchement (17) et l'interface de circuit d'entraînement (7), un filtre (18), de préférence un filtre CEM, est branché.

6. Unité de régulation et d'alimentation en énergie (1) selon une des revendications précédentes, **caractérisée en ce que** l'interface de circuit d'entraînement (7) et l'interface de moteur d'entraînement (6) sont accessibles de l'extérieur du logement (9) et de préférence reposent sur ou dans la paroi extérieure du logement (9), dans laquelle de préférence l'interface de circuit d'entraînement (7) et l'interface de moteur de compresseur (6) sont respectivement configurées sous forme d'une pièce enfichable.

7. Unité de régulation et d'alimentation en énergie (1) selon une des revendications précédentes, **caractérisée en ce que** entre les pôles de la liaison entre la sortie (12) du convertisseur CC/CC (10) et l'entrée (21) de l'onduleur (20, au moins une capacité intermédiaire (19) est branchée.

8. Unité de régulation et d'alimentation en énergie (1) selon une des revendications précédentes, **caractérisée en ce que** l'unité de régulation et d'alimentation en énergie (1) comprend une unité de mesure de tension (27), qui est conçue afin de mesurer la tension entre les pôles de la liaison entre la sortie (12) du convertisseur CC/CC (10) et l'entrée (21) de l'onduleur (20).

9. Unité de régulation et d'alimentation en énergie (1) selon une des revendications précédentes, **caractérisée en ce que** au moins un composant (13,14)du convertisseur CC/CC (10) et au moins un composant (13,23,24) de l'onduleur (20) sont alimentés par un dispositif d'alimentation en tension commun (29), dans laquelle de préférence le dispositif d'alimentation en tension (29) est renfermé dans un logement commun (9).

10. Unité de régulation et d'alimentation en énergie selon la revendication 9, **caractérisée en ce que** la liaison entre la sortie (12) du convertisseur CC/CC (10) et l'entrée de l'onduleur (21) présente un deuxième embranchement (28), qui est relié avec l'entrée du dispositif d'alimentation en tension commun (29).

11. Unité de régulation et d'alimentation en énergie selon une des revendications précédentes, **caractérisée en ce que** le convertisseur CC/CC (10) et l'onduleur (20) présentent au moins un dispositif de commande commun (13), notamment un contrôleur (13), un FPGA, un CPLD et/ou un ASIC, qui est renfermé dans le logement commun (9).

12. Unité de régulation et d'alimentation en énergie selon une des revendications précédentes, **caractérisée en ce que** le convertisseur CC/CC (10) et l'onduleur (20) s'entrecroisent au moins partiellement en ce qui concerne la disposition de leurs composants et/ou **en ce que** les composants (13,14,15,16) du convertisseur CC/CC (10) et des composants (13,23,24,25,26) de l'onduleur (20) reposent sur une platine commune (34).

13. Unité de régulation et d'alimentation en énergie selon une des revendications précédentes, **caractérisée en ce que** le convertisseur CC/CC (10) et l'onduleur (20) présentent une interface de commande commune (30), qui est accessible de l'extérieur du logement (9) et repose de préférence sur ou dans la paroi extérieure du logement (9), dans laquelle de préférence les interfaces de commande (30) sont configurées sous forme d'une pièce enfichable.

14. Unité de régulation et d'alimentation en énergie selon une des revendications précédentes, **caractérisée en ce que** le logement commun (9) comprend une alimentation de fluide de refroidissement (31) et une évacuation de fluide de refroidissement (32), dans laquelle des composants du convertisseur CC/CC (10) et des composants de l'onduleur (20) et le cas échéant une unité de pile à combustible (5) renfermée dans un logement commun sont refroidis par un circuit de fluide de refroidissement commun.

15. Entraînement de pile à combustible comportant un circuit d'entraînement (36), un moteur d'entraînement (38) relié avec le circuit d'entraînement (36), notamment un moteur de traction, une unité de pile à combustible (5) et un compresseur de pile à combustible (35), qui présente un moteur de compresseur (3), **caractérisé par** une unité de régulation et d'alimentation en énergie (1) selon une des revendications précédentes, dans lequel le circuit d'entraînement (36) est relié avec l'interface de circuit d'entraînement (7) de l'unité de régulation et d'alimentation en énergie (1) et le moteur de compresseur (3) est relié avec l'interface de moteur de compresseur (6) de l'unité de régulation et d'alimentation en énergie (1) et l'unité de pile à combustible (5) est reliée avec l'interface d'entrée de pile à combustible (11) du convertisseur CC/CC (10).

16. Véhicule à pile à combustible (2) comportant un entraînement de pile à combustible selon la revendication 15.
